# EUROPEAN PATENT APPLICATION

(11) **EP 4 585 661 A1**
(43) Date of publication of application: **16.07.2025**
(21) Application number: 24843553.9
(22) Date of filing: 19.07.2024
(51) Int. Cl.: C09J 133/06, C09J 183/06, C09J 11/04, C08L 33/06, C08L 83/06, C08L 63/00, C08G 59/50, C08G 59/62, C08G 59/42, H01L 23/00

(54) **ADHESIVE COMPOSITION FOR SEMICONDUCTOR PACKAGE**

(30) Priority: 20.07.2023 KR 20230094412; 18.07.2024 KR 20240095090
(71) Applicant: LG CHEM, LTD., Seoul 07336 (KR)
(72) Inventor: SUN, Yulin, Daejeon 34122 (KR); JANG, Jong Min, Daejeon 34122 (KR); LEE, Kwang Joo, Daejeon 34122 (KR); JUNG, Hyunhye, Daejeon 34122 (KR)
(74) Representative: Goddar, Heinz J.
(86) International application number: PCT/KR2024/010471
(87) International publication number: WO 2025/018840

(57) **Abstract**

An adhesive composition for a semiconductor package, the composition including a thermoplastic resin, a thermosetting resin and a curing agent, and having a relatively high storage modulus after curing under a prescribed condition; an adhesive film for a semiconductor; a dicing die bonding film; a semiconductor device; and a method for manufacturing a semiconductor device.

## Description

### CROSS-REFERENCE TO RELATED APPLICATION(S)

This application is a National Stage Application of International Application No. PCT/KR2024/010471 filed on July 19, 2024, which claims priority to and benefit of Korean Patent Application No. 10-2023-0094412 filed on July 20, 2023 and Korean Patent Application No. 10-2024-0095090 filed on July 18, 2024 in the Korean Intellectual Property Office, the disclosures of which are incorporated herein by reference in their entirety.

### TECHNICAL FIELD

The present disclosure relates to an adhesive composition for a semiconductor package, an adhesive film for a semiconductor, a semiconductor device, and a method for manufacturing a semiconductor device.

### BACKGROUND

A necessity for high density and high integration of a semiconductor package is increasing. Accordingly, the size of semiconductor chips becomes larger and larger, and in order to improve integration degree, a stack package method for stacking semiconductor chips in multiple stages is widely applied.

Due to the trend toward miniaturization of semiconductor package size and increase in capacity, the demand for die applications that apply thinner semiconductor chips is increasing.

However, due to the thin thickness of the semiconductor chips, cracks may occur in the semiconductor chip during a packaging process, or a phenomenon where the semiconductor chip warps or deflects may occur, which not only makes it difficult to proceed with the continuous processes of manufacturing semiconductor packages, but can also reduce the reliability of the final product.

### BRIEF DESCRIPTION

It is an object of the present disclosure to provide an adhesive composition for a semiconductor package that can prevent occurrence of cracks or warpage in semiconductor chips even during a packaging process applying a semiconductor chip having a thin thickness, and are excellent in adhesive force and embedding properties.

It is another object of the present disclosure to provide an adhesive film for a semiconductor comprising the adhesive composition for a semiconductor package.

It is another object of the present disclosure to provide a dicing die bonding film comprising the adhesive film for a semiconductor.

It is yet another object of the present disclosure to provide a semiconductor device having high reliability and internal structural stability even while including a semiconductor chip having a thin thickness.

It is a further object of the present disclosure to provide a method for manufacturing a semiconductor device that can prevent occurrence of cracks or warpage in semiconductor chips even during a packaging process applying a semiconductor chip having a thin thickness, and can realize excellent adhesive force and embedding properties between a substrate and a semiconductor chip or between two or more semiconductor chips.

Provided herein is an adhesive composition for a semiconductor package, comprising: a thermoplastic resin, a thermosetting resin and a curing agent, wherein a storage modulus at 130°C measured after curing under the conditions of a temperature of 120°C to 300°C and a pressure of 0.5 Kgf/ cm² to 10 Kgf/ cm² is 30 MPa or more.

Also provided herein is an adhesive film for a semiconductor comprising the adhesive composition for a semiconductor package.

Further provided herein is a dicing die bonding film comprising the adhesive film for a semiconductor.

Further provided herein is a semiconductor device comprising: a substrate; one or more semiconductor chips formed on the substrate; and an adhesive layer located between the substrate and the semiconductor chips formed on the substrate, or between two or more semiconductor chips among the semiconductor chips, wherein the adhesive layer comprises a cured product of the adhesive composition for a semiconductor package.

### DETAILED DESCRIPTION

Now, an adhesive composition for a semiconductor package, a semiconductor device, and a method for manufacturing a semiconductor device according to specific embodiments of the present disclosure will be described in more detail.

Unless otherwise specified throughout this specification, the technical terms used herein are only for reference to specific embodiments and is not intended to limit the present disclosure.

The singular forms "a", "an", and "the" used herein include plural references unless the context clearly dictates otherwise.

The term "including" or "comprising" used herein specifies a specific feature, region, integer, step, action, element and/or component, but does not exclude the presence or addition of a different specific feature, region, integer, step, action, element, component and/or group.

The term "(meth)acrylate" as used herein includes both acrylate and methacrylate.

According to an embodiment of the disclosure, there can be provided an adhesive composition for a semiconductor package comprising: a thermoplastic resin, a thermosetting resin and a curing agent, wherein a storage modulus at 130°C measured after curing under the conditions of a temperature of 120°C to 300°C and a pressure of 0.5 Kgf/ cm² to 10 Kgf/ cm² is 30 MPa or more.

The present inventors have confirmed that when an adhesive composition for a semiconductor package having a storage modulus of 30 MPa or more at 130°C as measured after curing under a prescribed condition is used, it is possible to prevent occurrence of cracks or warpage in semiconductor chips even during a packaging process applying a semiconductor chip having a thin thickness, and to have excellent adhesive force and embedding properties, and completed the invention.

The storage modulus at 130°C measured after curing the adhesive composition for semiconductor package under the conditions of a temperature of 120°C to 300°C and a pressure of 0.5 Kgf/ cm² to 10 Kgf/ cm² may be 30 MPa or more, 50 MPa or more, or 50 to 500 MPa, or 60 to 400 MPa.

In the step of curing the adhesive composition for a semiconductor package under the conditions of a temperature of 120°C to 300°C and a pressure of 0.5 Kgf/ cm² to 10 Kgf/ cm², the pressure conditions of 0.5 Kgf/ cm² to 10 Kgf/ cm², or 1 Kgf/ cm² to 8 Kgf/ cm² may be applied.

The step of curing the adhesive composition for a semiconductor package under the conditions of a temperature of 120°C to 300°C and a pressure of 0.5 Kgf/ cm² to 10 Kgf/ cm² may change the curing time in consideration of specific curing conditions, etc., and can be performed for 10 to 200 minutes, including the curing step and the steps before and after it.

More specifically, the curing under the conditions of a temperature of 120°C to 300°C and a pressure of 0.5 Kgf/ cm² to 10 Kgf/ cm² may be performed under the pressure condition of 7 Kgf/ cm², which comprises: a step of increasing the temperature from 25°C to 125°C for 30 minutes, a step of maintaining the temperature at 125°C for 30 minutes after the temperature increase, and a step of cooling the temperature to 60°C after the maintaining.

Conventionally known adhesive films for semiconductor often have a storage modulus at 130°C measured after curing which is in a very low range of, for example, 10 MPa or less.

In contrast, as the adhesive composition for a semiconductor package has a storage modulus at 130°C measured after curing in the above-mentioned range, it is possible to greatly reduce the stress applied to the semiconductor chip or greatly reduce the strain of the semiconductor chip while firmly bonding to a semiconductor chip having a thin thickness, for example, a thickness of 100 µm or less or 50 µm or less. Thereby, as the adhesive composition for semiconductor package of the above embodiment is used as mentioned above, it is possible to prevent occurrence of cracks and warpage in semiconductor chips even during the packaging process applying a semiconductor chip having a thin thickness.

However, the "curing under the conditions of a temperature of 120°C to 300°C and a pressure of 0.5 Kgf/cm² to 10 Kgf/cm²" is not intended to limit a specific use or process to which the adhesive composition for semiconductor package of the above embodiment is applied, but is a specific condition set to define the storage modulus at 130°C processed by the adhesive composition for a semiconductor package of the above embodiment after curing.

The adhesive composition for a semiconductor package may be used for the purpose of connecting a substrate and a semiconductor chip having a thickness of 100 µm or less or 50 µm or less, or for the purpose of connecting two or more semiconductor chips having a thickness of 100 µm or less or 50 µm or less.

The semiconductor chip may have a thickness of 100 µm or less, or 50 µm or less, 40 µm or less, 30 µm or less, or 1 µm or more, 2 µm or more, 5 µm or more, or 10 µm or more.

The storage modulus at 130°C is measured using a DMA (Dynamic mechanical analysis) device at a frequency of 1 Hz and a strain of 0.0%, wherein the storage modulus (G') according to the temperature is measured while increasing the temperature from - 30°C to 280°C at a rate of 10°C per minute, thereby being capable of confirming the storage modulus at 130°C of the cured adhesive composition for a semiconductor package.

Meanwhile, the adhesive composition for a semiconductor package may not contain an inorganic filler in an excessive amount or may be substantially free of an inorganic filler, but may have a storage modulus at 130°C of 30 MPa or more as measured after curing under the conditions of a temperature of 120°C to 300°C and a pressure of 0.5 to 10 Kgf/cm².

When an adhesive composition or an adhesive film containing an excessive amount of inorganic filler is used in a packaging process applying a semiconductor chip having a thin thickness, it can increase the stress applied to the semiconductor chip or cause shape deformation of the semiconductor chip, and may also increase the viscosity of the film, which may be unfavorable for embedding properties.

In contrast, since the adhesive composition for a semiconductor package substantially uses an inorganic filler in a small amount or does not contain it, it is possible to prevent occurrence of cracks or warpage in the semiconductor chip even in the packaging process applying a semiconductor chip having a thin thickness.

More specifically, the adhesive composition for a semiconductor package may contain an inorganic filler in an amount of 5 wt.% or less, 4.9 wt.% or less, 4.8 wt.% or less, 4.6 wt.% or less, or 1 wt.% or less, 0.1 wt.% or less, or 0.01 wt.% or less, and may be substantially free of an inorganic filler.

The adhesive composition for a semiconductor package may not contain an inorganic filler, or the adhesive composition for a semiconductor package may further contain an inorganic filler in an amount of 4.9 wt.% or less.

The specific type of the inorganic filler is not particularly limited, and the inorganic filler may be inorganic fine particles having a particle size of 1000 µm or less.

Meanwhile, the melt viscosity of the adhesive composition for a semiconductor package measured at 110°C by applying a shear rate of 5 rad/s may be 3,000 Pa·s to 50,000 Pa·s, or 4,000 Pa·s to 30,000 Pa·s, or 4,500 Pa·s to 25,000 Pa·s, or 4,000 Pa·s to 20,000 Pa·s.

The melt viscosity may be a value measured before the adhesive composition for a semiconductor package is cured as described above.

The melt viscosity of the adhesive composition for a semiconductor package can be measured by a known method, and for example, the adhesive composition for a semiconductor package may be produced in the form of an adhesive film to measure the melt viscosity.

More specifically, the adhesive film specimen obtained from the adhesive composition for a semiconductor package is laminated to a thickness of 300 *µ*m to 800 *µ*m, then laminated using a roll laminator at 60°C, and then molded into a circle with a diameter of 8 mm, and the melt viscosity can be measured by a method such as using TA Instruments ARES-G2. At this time, the melt viscosity can also be a viscosity value measured at 110°C by applying a temperature increase rate of 20°C/min at a shear rate of 5 Rad/s.

The melt viscosity means an absolute magnitude indicating a sticky degree that a material in a fluid state resists against the direction of movement.

The adhesive composition for a semiconductor package can undergo a die attach process at a temperature of around 110°C during a semiconductor package process. However, since the melt viscosity of the adhesive composition for a semiconductor package measured at 110°C is 3,000 Pa·s to 50,000 Pa·s, or 4,000 Pa·s to 30,000 Pa·s, the space formed between a substrate and a semiconductor chip or between two or more semiconductor chips can be efficiently embedded, thereby preventing a phenomenon in which a void occurs or the state of connection becomes poor.

As mentioned above, the adhesive composition for a semiconductor package may comprise a thermoplastic resin.

Examples of the thermoplastic resin include (meth)acrylate resins, polyimide, polyether imide, polyester imide, polyamide, polyether sulfone, polyether ketone, polyvinyl chloride, polybutadiene resins, acrylonitrile-butadiene copolymer, acrylonitrile-butadiene-styrene resins, styrene-butadiene copolymer, phenoxy resins, and the like.

The thermoplastic resin may have a glass transition temperature of -50°C to 70°C. By using the thermoplastic resin having the above-mentioned glass transition temperature, the finally produced adhesive film for a semiconductor can secure high adhesive strength and can be easily produced in the form of a thin film, etc.

Meanwhile, the (meth)acrylate resin including the repeating unit substituted with a glycidyl group or an epoxy group has a feature that the density in a reactor is high, and can have a glass transition temperature of -20°C to 30°C.

Here, if the epoxy group content in the (meth)acrylate resin is less than 1 wt.%, the compatibility and adhesive force with the epoxy resin are not sufficient, and if the content is greater than 30 wt.%, the rate of viscosity increase due to curing is too fast, so that the embedding or adhesive force of an adhesion target may not be sufficiently achieved.

The (meth)acrylate resin containing the repeating unit substituted with a glycidyl group or an epoxy group may have a weight average molecular weight of 50,000 g/mol to 1,200,000 g/mol.

As a non-limiting example, the weight average molecular weight can be measured using an Agilent PL-GPC 220 instrument equipped with a 300 mm long PolarGel MIXED-L column (Polymer Laboratories). A measurement temperature is 65°C, dimethylformamide is used as a solvent, and the flow rate is 1 mL/min. The sample is prepared at a concentration of 10 mg/10 mL and then supplied in an amount of 100 µL. The values of Mw and Mn are derived using a calibration curve formed using a polystyrene standard. 8 kinds of the polystyrene standards were used with the molecular weight of 580/ 3,940/ 8,450/ 31,400/ 70,950/ 316,500/ 956,000/ 4,230,000.

The (meth)acrylate resin is an epoxy group-containing acrylic copolymer, and may contain glycidyl acrylate or glycidyl methacrylate in an amount of 1 to 30 wt.%, or 2 to 20 wt.%, or 2.5 to 15 wt.% based on the total weight.

If the epoxy group content in the (meth)acrylate resin is less than 1 wt.%, the compatibility and adhesive force with the epoxy resin are not sufficient, and if the content is greater than 30 wt.%, the rate of viscosity increase due to curing may be too fast, so that the embedding or adhesion of the adhesion target may not be sufficiently achieved.

The content of the thermoplastic resin may be determined in consideration of the flowability of the composition during the production of the adhesive film, the physical properties of the final adhesive film, etc.

Meanwhile, the thermoplastic resin may include two or more kinds of (meth)acrylate-based resins having different glass transition temperatures.

More specifically, the thermoplastic resin may include: a (meth)acrylate resin containing a repeating unit substituted with a glycidyl group or an epoxy group and having a glass transition temperature of -20°C to 5°C; and a (meth)acrylate resin containing a repeating unit substituted with a glycidyl group or an epoxy group and having a glass transition temperature of 7°C to 30°C.

The (meth)acrylate resins having different glass transition temperatures may each have a weight average molecular weight of 50,000 to 1,500,000.

Since the thermoplastic resin includes a (meth)acrylate-based resin containing a repeating unit substituted with a glycidyl group or an epoxy group and having a glass transition temperature of -20°C to 5°C, the adhesive composition for semiconductor package can realize higher workability, thereby making it easier to process into a form such as a film.

Further, since the thermoplastic resin includes a (meth)acrylate-based resin containing a repeating unit substituted with a glycidyl group or an epoxy group and having a glass transition temperature of 7°C to 30°C, the adhesive composition for semiconductor package may have enhanced wettability characteristics for the wafer along with a higher storage modulus (130°C).

As mentioned above, the adhesive composition for a semiconductor package may include a thermosetting resin.

More specifically, the thermosetting resin may include a silsesquioxane compound substituted with a glycidyl group or an epoxy group.

Accordingly, when the adhesive composition for a semiconductor package including the silsesquioxane compound substituted with a glycidyl group or an epoxy group is used, it is possible to prevent occurrence of cracks or warpage in the semiconductor chip even during a packaging process applying a semiconductor chip having a thin thickness, and to achieve excellent adhesive force and embedding properties.

The silsesquioxane compound substituted with a glycidyl group or an epoxy group can include an organic-inorganic hybrid epoxy resin having a repeating unit represented by the following Chemical Formula 1. 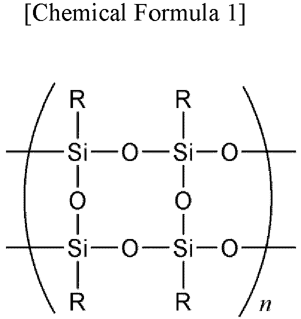 wherein in Chemical Formula 1, each R is independently a monovalent functional group having one or more epoxy groups, and n is 1 to 30.

Each R in Chemical Formula 1 may be independently any one functional group selected from the group consisting of the following structural formulas: 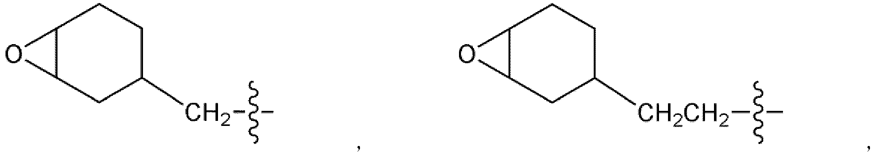 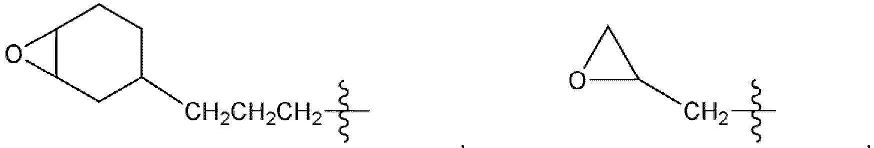 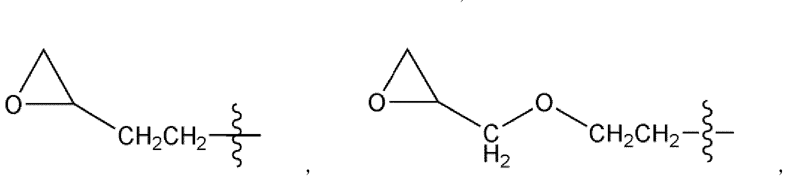 and

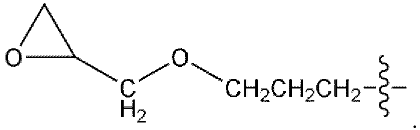

**In** the present disclosure, the notation 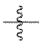 represents a portion where the corresponding functional group is linked to another group.

The organic-inorganic hybrid epoxy resin may have an average epoxy equivalent of 50 g/eq. to 300 g/eq. The average epoxy equivalent is a value calculated based on the weight ratio and epoxy equivalent of each epoxy resin contained in the organic-inorganic hybrid epoxy resin.

Preferably, the organic-inorganic hybrid epoxy resin may have an average epoxy equivalent of 50 g/eq. to 300 g/eq., or 100 g/eq. to 300 g/eq., or 100 g/eq. to 250 g/eq., or 150 g/eq. to 250 g/eq., or 150 g/eq. to 200 g/eq., or 160 g/eq. to 180 g/eq.

In order to realize the effect due to the addition of the organic-inorganic hybrid epoxy resin, the organic-inorganic hybrid epoxy resin preferably has an average epoxy equivalent of 50 g/eq. or more. However, an excessively high epoxy equivalent may deteriorate the physical properties of the adhesive composition for a semiconductor package. Therefore, the organic-inorganic hybrid epoxy resin preferably has an average epoxy equivalent of 300 g/eq. or less.

The organic-inorganic hybrid epoxy resin preferably has a viscosity measured at 25°C of 0.1 Pa·s to 10,000 Pa·s, or 0.5 Pa·s to 5,000 Pa·s.

If the viscosity of the organic-inorganic hybrid epoxy resin is too high, the physical properties of the adhesive composition for a semiconductor package and the physical properties of the adhesive film may deteriorate. Therefore, the organic-inorganic hybrid epoxy resin preferably have a viscosity of 10,000 Pa·s or less.

The thermosetting resin may further include an epoxy resin together with a silsesquioxane compound substituted with a glycidyl group or an epoxy group.

Specific examples of such epoxy resins include a bisphenol-based epoxy resin, a biphenyl-based epoxy resin, a naphthalene-based epoxy resin, a fluorene-based epoxy resin, a phenol novolac-based epoxy resin, a cresol novolac-based epoxy resin, a xylok-based epoxy resin, a trishydroxylphenylmethane-based epoxy resin, a tetraphenylmethane-based epoxy resin, a dicyclopentadiene type epoxy resin, a dicyclopentadiene-modified phenol type epoxy resin, or a mixture or copolymer of two or more kinds thereof.

More specifically, when the thermosetting resin further comprises an epoxy resin together with a silsesquioxane compound substituted with a glycidyl group or an epoxy group, the epoxy resin may be a biphenyl-based epoxy resin having a softening point of 50°C to 100°C, a cresol novolac-based epoxy resin having a softening point of 50°C to 100°C, or a bisphenol A epoxy resin having a softening point of 50°C to 100°C.

When the thermosetting resin further includes an epoxy resin together with a silsesquioxane compound substituted with a glycidyl group or an epoxy group, the epoxy resin may be included in an amount of 10 to 500 parts by weight relative to 100 parts by weight of the silsesquioxane compound substituted with a glycidyl group or an epoxy group.

Meanwhile, the adhesive composition for a semiconductor package may include at least one compound selected from the group consisting of an amine-based curing agent, a phenol-based curing agent, and an acid anhydride-based curing agent as the curing agent.

As the curing agent, a novolac-based phenol resin can be preferably applied.

The novolac-based phenol resin has a chemical structure in which a ring is positioned between reactive functional groups. Due to such structural characteristics, the novolac-based phenol resin can further reduce the hygroscopicity of the adhesive composition and further increase the stability in a high-temperature IR reflow process, which can play a role in preventing peeling phenomenon or reflow cracking of the adhesive film.

Specific examples of the novolac-based phenol resin include at least one selected from the group consisting of a novolac phenol resin, a xylok novolac phenol resin, a cresol novolac phenol resin, a biphenyl novolac phenol resin, a bisphenol A novolac phenol resin, and a bisphenol F novolac phenol resin.

As the novolac-based phenol resin, those having a softening point of 60°C or more, or 60°C to 150°C, or 105°C to 150°C, or 70°C to 120°C can preferably be applied.

The novolac phenol resin having a softening point of 60°C or more is capable of exhibiting sufficient heat resistance, strength, and adhesive properties after curing the adhesive composition. However, if the softening point of the novolac-based phenol resin is too high, the flowability of the adhesive composition becomes low, and voids are created inside the adhesive in an actual semiconductor production process, which may greatly reduce the reliability or quality of the final product.

The novolac-based phenol resin preferably has a hydroxyl equivalent of 80 g/eq to 300 g/eq and a softening point of 60°C to 150°C.

The adhesive composition for a semiconductor package can appropriately adjust the content of each of the thermoplastic resin, the thermosetting resin, and the curing agent in consideration of specific physical properties, etc., and for example, the adhesive composition for semiconductor package can include 5 to 500 parts by weight of the thermoplastic resin and 1 to 150 parts by weight of the curing agent relative to 100 parts by weight of the thermosetting resin.

The adhesive composition for a semiconductor package may further include at least one compound selected from the group consisting of a phosphorus-based compound, a boron-based compound, a phosphorus-boron-based compound, and an imidazole-based compound as the curing catalyst.

The curing catalyst serves to promote the action of the curing agent or the curing of the resin composition for semiconductor adhesion, and any curing catalyst known to be used in the production of semiconductor adhesive films, etc. can be used without considerable limitation.

The content of the curing catalyst can be adjusted in consideration of the content of the curing agent and the physical properties of the finally produced adhesive film. For example, the curing catalyst can be used in an amount of 0.1 to 20 parts by weight, or 0.5 to 15 parts by weight, or 1.0 to 10 parts by weight, or 1.5 to 5 parts by weight, or 1.5 to 3 parts by weight, based on 100 parts by weight of the thermosetting resin.

The adhesive composition for a semiconductor package may further contain an organic solvent.

The content of the organic solvent may be determined in consideration of the physical properties of the adhesive composition and the adhesive film containing the same, and the productivity of these production processes.

For example, the organic solvent may be included in an amount of 10 to 90 parts by weight based on 100 parts by weight of the total of the thermosetting resin, the thermoplastic resin, the curing agent, and other additives.

The organic solvent may be at least one compound selected from the group consisting of esters, ethers, ketones, aromatic hydrocarbons, and sulfoxides.

The ester solvent may be ethyl acetate, n-butyl acetate, isobutyl acetate, amyl formate, isoamyl acetate, isobutyl acetate, butyl propionate, isopropyl butyrate, ethyl butyrate, butyl butyrate, methyl lactate, ethyl lactate, gamma-butyrolactone, epsilon-caprolactone, delta-valerolactone, alkyl oxyacetate, for example, methyl oxyacetate, ethyl oxyacetate, methyl methoxyacetate, ethyl methoxyacetate, butyl methoxyacetate, methyl ethoxyacetate, ethyl ethoxyacetate, methyl 3-oxypropionate, ethyl 3-oxypropionate, etc., methyl 3-methoxypropionate, ethyl 3-methoxypropionate, methyl 3-ethoxypropionate, ethyl 3-ethoxypropionate, methyl 2-oxypropionate, ethyl 2-oxypropionate, methyl 2-methoxypropionate, ethyl 2-methoxypropionate, propyl 2-methoxypropionate, methyl 2-ethoxypropionate, ethyl 2-ethoxypropionate, methyl 2-oxy-2-methylpropionate, methyl 2-methoxy-2-methylpropionate, ethyl 2-ethoxy-2-methylpropionate, methyl pyruvate, ethyl pyruvate, propyl pyruvate, methyl acetoacetate, ethyl acetoacetate, methyl 2-oxobutanoate, ethyl 2-oxobutanoate, etc.

The ether solvent may be diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate, etc.

The ketone solvent may be methyl ethyl ketone, cyclohexanone, cyclopentanone, 2-heptanone, 3-heptanone, N-methyl-2-pyrrolidone, etc.

The aromatic hydrocarbon solvent may include toluene, xylene, anisole, limonene, etc.

The sulfoxide solvent may be dimethyl sulfoxide, etc.

The adhesive composition for a semiconductor package may further include a coupling agent.

The type of the coupling agent is not particularly limited, but preferably, 2-(3,4 epoxycyclohexyl)-ethyltrimethoxysilane, 3-glycidoxypropyltrimethoxysilane, 3-glycidoxypropylmethyl-diethoxysilane, 3-glycidoxypropyltriethoxysilane, N-2(aminoethyl)3-aminopropylmethyldimethoxysilane, N-2(aminoethyl)3-aminopropyltrimethoxysilane, N-2(aminoethyl)3-aminopropyltriethoxysilane, 3-aminopropyltrimethoxysilane, 3-aminopropyltriethoxysilane, 3-triethoxyl-N-(1,3-dimethylbutylidene)propylamine, N-phenyl-3-aminopropyltrimethoxysilane, 3-mercaptopropylmethyldimethoxysilane containing mercapto, 3-mercaptopropyltrimethoxysilane, etc. can be applied preferably.

The phenols may be a compound having at least two phenolic hydroxyl groups.

For example, the phenols may be catechol, resorcinol, hydroquinone, biphenol, dihydroxynaphthalene, hydroxyhydroquinone, pyrogallol, methylidene biphenol (bisphenol F), isopropylidene biphenol (bisphenol A), ethylidene biphenol (bisphenol AD), 1,1,1-tris(4-hydroxyphenyl)ethane, trihydroxybenzophenone, trihydroxyacetophenone, poly-p-vinylphenol, etc.

As the compound having at least two phenolic hydroxyl groups, at least one compound selected from compounds having at least one phenolic hydroxyl group in the molecule; an aromatic compound having two halomethyl groups, alkoxymethyl groups or hydroxylmethyl groups in the molecule; and a polycondensate of divinylbenzene and at least one compound selected from aldehydes can be applied.

The compound having at least one phenolic hydroxyl group in the molecule may include phenol, alkylphenol, naphthol, cresol, catechol, resorcinol, hydroquinone, biphenol, dihydroxynaphthalene, hydroxyhydroquinone, pyrogallol, methylidene biphenol (bisphenol F), isopropylidene biphenol (bisphenol A), ethylidene biphenol (bisphenol AD), 1,1,1-tris(4-hydroxyphenyl)ethane, trihydroxybenzophenone, trihydroxyacetophenone, or poly(p-vinylphenol). In addition, the aromatic compound having two halomethyl groups, alkoxymethyl groups or hydroxylmethyl groups in the molecule may include, for example, 1,2-bis(chloromethyl)benzene, 1,3-bis(chloromethyl)benzene, 1,4-bis(chloromethyl)benzene, 1,2-bis(methoxymethyl)benzene, 1,3-bis(methoxymethyl)benzene, 1,4-bis(methoxymethyl)benzene, 1,2-bis(hydroxymethyl)benzene, 1,3-bis(hydroxymethyl)benzene, 1,4-bis(hydroxymethyl)benzene, or bis(chloromethyl)biphenyl, bis(methoxymethyl)biphenyl.

The aldehydes may include formaldehyde (formalin as an aqueous solution thereof), paraformaldehyde, trioxane, or hexamethylenetetramine.

The polycondensate may include a phenol novolac resin which is a polycondensate of phenol and formaldehyde, a cresol novolac resin which is a polycondensate of cresol and formaldehyde, a naphthol novolac resin which is a polycondensate of naphthols and formaldehyde, a phenol aralkyl resin which is a polycondensate of phenol and 1,4-bis(methoxymethyl)benzene, a polycondensate of bisphenol A and formaldehyde, a polycondensate of phenol and divinylbenzene, or a polycondensate of cresol, naphthol and formaldehyde. And, these polycondensates may be modified with rubber, or may be compounds in which an aminotriazine skeleton or dicyclopentadiene skeleton is introduced into the molecular skeleton.

In addition, a compound obtained by allylating and liquefying a compound having the phenolic hydroxyl group may include an allylated phenol novolac resin, a diallylbisphenol A, a diallylbisphenol F, a diallylbiphenol, etc.

The alcohols may be compounds having at least two alcoholic hydroxyl groups in the molecule.

For example, the alcohols may be 1,3-dioxane-5,5-dimethanol, 1,5-pentanediol, 2,5-furanmethanol, diethylene glycol, tetraethylene glycol, pentaethylene glycol, hexaethylene glycol, 1,2,3-hexanetriol, 1,2,4-butanetriol, 1,2,6-hexanetriol, 3-methylpentane-1,3,5-triol, glycerin, trimethylolethane, trimethylolpropane, erythritol, pentaerythritol, ribitol, sorbitol, 2,4-diethyl-1,5-pentanediol, propylene glycol monomethyl ether, propylene glycol monoethyl ether, 1,3-butylene glycol, 2-ethyl-1,3-hexanediol, N-butyldiethanolamine, N-ethyldiethanolamine, diethanolamine, triethanolamine, N,N-bis(2-hydroxyethyl)isopropanolamine, bis(2-hydroxymethyl)iminotris(hydroxymethyl)methane, N,N,N',N'-tetrakis(2-hydroxyethyl)ethylenediamine, 1',1",1"'-(ethylenedinitrilo)tetrakis(2-propanol), etc.

Meanwhile, according to another embodiment of the present disclosure, there can be provided an adhesive film for a semiconductor comprising the adhesive composition for semiconductor package of the above embodiment.

The adhesive composition for a semiconductor package may be in the form of an adhesive film.

The adhesive film may include an adhesive layer in which the adhesive composition for a semiconductor package is dried or cured.

The adhesive film for a semiconductor may each have a thickness of 1 *µ*m to 300 *µ*m. The thickness may mean the thickness of a single layer or one layer of the adhesive film for semiconductor. Also, the adhesive film for a semiconductor may each have a thickness of 1 *µ*m or more, 3 *µ*m or more, 5 *µ*m or more, or 10 *µ*m or more. In addition, the adhesive film for a semiconductor may each have a thickness of 300 *µ*m or less, or 100 *µ*m or less, or 90 *µ*m or less, or 70 *µ*m or less. When the thickness of the adhesive film for a semiconductor increases or decreases by a specific numerical value, the physical properties measured in the adhesive film for semiconductor may also change by a prescribed numerical value.

Further, the adhesive film for a semiconductor may be in the form of a multilayer film in which one film having a thickness of 1 *µ*m to 300 *µ*m forms a plurality of layers.

The adhesive film can be used as a die attach film (DAF) that bonds a lead frame or a substrate to a die, or bonds dies to each other. Thereby, the adhesive film can be processed into a form such as a die bonding film or a dicing die bonding film.

The adhesive film can have a configuration in which a support substrate and an adhesive layer are laminated in sequence.

The adhesive film can have a configuration in which a support substrate, an adhesive layer, and a protective film are laminated in sequence.

The adhesive film can have a configuration in which a support substrate, an adhesive layer, an adhesive layer, and a protective film are laminated in sequence.

As the support substrate, a resin film having excellent heat resistance or chemical resistance; a crosslinked film obtained by subjecting a resin constituting the resin film to crosslinking treatment; or a film obtained by applying a silicone resin or the like to the surface of the resin film and subjecting it to a peeling treatment, can be used.

As the resin constituting the resin film, polyolefins such as polyester, polyethylene, polypropylene, polybutene, and polybutadiene, vinyl chloride, ethylene-methacrylic acid copolymer, ethylene vinyl acetate copolymer, polyester, polyimide, polyethylene terephthalate, polyamide, and polyurethane can be applied.

The thickness of the support substrate is not particularly limited, but may be 3 to 400 *µ*m, or 5 to 200 *µ*m, or 10 to 150 *µ*m.

The adhesive layer may include the adhesive composition for a semiconductor package described above. The details regarding the adhesive composition for a semiconductor package are as described above.

The type of the protective film is not particularly limited, and a plastic film known in this field can be applied. For example, the above protective film may be a plastic film including a resin, such as: a low density polyethylene, a linear polyethylene, a medium density polyethylene, a high density polyethylene, an ultra-low density polyethylene, a random copolymer of polypropylene, a block copolymer of polypropylene, a homopolypropylene, a polymethylpentene, an ethylene-vinyl acetate copolymer, an ethylene-methacrylic acid copolymer, an ethylene-methyl methacrylate copolymer, an ethylene-ionomer copolymer, an ethylene-vinyl alcohol copolymer, polybutene, styrene copolymer.

According to another embodiment of the present disclosure, there can be provided a dicing die bonding film comprising: a substrate film; a cohesive layer formed on the substrate film; and an adhesive layer formed on the cohesive layer and containing the adhesive film for a semiconductor of the other embodiments.

Specific details regarding the adhesive film for a semiconductor are as described above in other embodiments.

The type of the substrate film contained in the dicing die bonding film is not particularly limited, and for example, a plastic film or a metal foil known in this field can be used. For example, the substrate film may include a low density polyethylene, a linear polyethylene, a medium density polyethylene, a high density polyethylene, an ultra-low density polyethylene, a random copolymer of polypropylene, a block copolymer of polypropylene, a homopolypropylene, a polymethylpentene, an ethylene-vinyl acetate copolymer, an ethylene-methacrylic acid copolymer, an ethylene-methyl methacrylate copolymer, an ethylene-ionomer copolymer, an ethylene-vinyl alcohol copolymer, polybutene, styrene copolymer, or a mixture of two or more thereof. The term "the substrate film containing a mixture of two or more polymers" as used herein includes a film having a structure in which two or more layers of films each containing the aforementioned polymers are laminated, or a single-layer film containing two or more of the aforementioned polymers.

The thickness of the substrate film is not particularly limited, and is usually formed to a thickness of 10 *µ*m to 200 *µ*m, preferably 50 *µ*m to 180 *µ*m. If the thickness is less than 10 *µ*m, there is a possibility that the adjustment of the cut depth in the dicing process becomes unstable, and if the thickness is greater than 200 *µ*m, there is a possibility that a large number of burrs is generated in the dicing process, or the stretching rate may decrease, and thus the expanding process may not be performed accurately.

Conventional physical or chemical treatments such as matting treatment, corona discharge treatment, primer treatment, or crosslinking treatment may be performed on the substrate film, if necessary.

Meanwhile, the cohesive layer may contain an ultraviolet-curable adhesive or a heat-curable adhesive. When an ultraviolet-curable adhesive is used, ultraviolet light is irradiated from the substrate film side to increase the cohesive force and glass transition temperature of the adhesive and reduce the adhesive force, and when a heat-curable adhesive is used, the cohesive force is reduced by applying temperature.

At the same time, the ultraviolet-curable adhesive may contain a (meth)acrylate resin, an ultraviolet-curable compound, a photoinitiator, and a crosslinking agent.

The (meth)acrylate resin may have a weight average molecular weight of 100,000 g/mol to 1,500,000 g/mol, preferably 200,000 g/mol to 1,000,000 g/mol. If the weight average molecular weight is less than 100,000 g/mol, the coating properties or cohesive force may decrease, and residue may remain on the adherend during peeling, or the adhesive may be destroyed. Further, if the weight average molecular weight exceeds 1,500,000 g/mol, the substrate resin may hinder the reaction of the ultraviolet-curable compound, and the peeling strength may not be reduced efficiently.

Such a (meth)acrylate resin may be, for example, a copolymer of a (meth)acrylic acid ester monomer and a crosslinkable functional group-containing monomer. In this case, an example of the (meth)acrylic acid ester monomer may be alkyl (meth)acrylate. More specifically, examples of monomers having an alkyl group having 1 to 12 carbon atoms include any one or combination of two or more of: pentyl (meth)acrylate, n-butyl (meth)acrylate, ethyl (meth)acrylate, methyl (meth)acrylate, hexyl (meth)acrylate, n-octyl (meth)acrylate, isooctyl (meth)acrylate, 2-ethylhexyl (meth)acrylate, dodecyl (meth)acrylate, or decyl (meth)acrylate. As monomers having a large number of alkyl carbon atoms are used, the glass transition temperature of the final copolymer decreases, so that an appropriate monomer may be selected according to the desired glass transition temperature.

Examples of the crosslinkable functional group-containing monomers include any one or combination of two or more of: hydroxyl group-containing monomers, carboxyl group-containing monomers, and nitrogen-containing monomers. In this case, examples of the hydroxyl group-containing compound include 2-hydroxyethyl (meth)acrylate or 2-hydroxypropyl (meth)acrylate, examples of the carboxyl group-containing compound include (meth)acrylic acid, and examples of the nitrogen-containing monomer include (meth)acrylonitrile, N-vinylpyrrolidone, or N-vinylcaprolactam, but are not limited thereto.

The (meth)acrylate resin may further contain vinyl acetate, styrene, or acrylonitrile carbon-carbon double bond-containing low molecular weight compound from the viewpoint of improving other functionality such as compatibility.

The type of the ultraviolet curing compound is not particularly limited, and for example, a polyfunctional compound (e.g., polyfunctional urethane acrylate, polyfunctional acrylate monomer, or oligomer) having a weight average molecular weight of 100 g/mol to 300,000 g/mol, or 500 g/mol to 100,000 g/mol can be used. A person of average skill in this field can easily select an appropriate compound according to the intended use.

The content of the ultraviolet curing compound may be preferably 5 parts by weight to 400 parts by weight, and more preferably 10 parts by weight to 200 parts by weight, relative to 100 parts by weight of the base resin described above. If the content of the ultraviolet curing compound is less than 5 parts by weight, the adhesive strength after curing may not decrease sufficiently, and the pick-up property may decrease. If the content exceeds 400 parts by weight, the cohesive force of the cohesive agent before ultraviolet irradiation may be insufficient, or peeling from a release film or the like may not be easily achieved.

The type of the photoinitiator is also not particularly limited, and a general initiator known in this field can be used, and the content thereof may be 0.05 to 20 parts by weight relative to 100 parts by weight of the ultraviolet curing compound. If the content of the photoinitiator is less than 0.05 parts by weight, the curing reaction due to ultraviolet irradiation may be insufficient, which may result in a decrease in pick-up properties. If the content exceeds 20 parts by weight, the crosslinking reaction may occur in short units during the curing process, or unreacted ultraviolet curing compound may be generated, which may cause residue on the surface of the adherend, or the peeling force may be excessively low after curing, which results in a decrease in pick-up properties.

Further, the type of the crosslinking agent contained in the cohesive portion to provide adhesive force and cohesive force is not particularly limited, and conventional compounds such as isocyanate-based compounds, aziridine-based compounds, epoxy-based compounds, or metal chelate-based compounds can be used. The crosslinking agent can be included in an amount of 2 parts by weight to 40 parts by weight, preferably 2 parts by weight to 20 parts by weight, based on 100 parts by weight of the base resin. If the content is less than 2 parts by weight, the cohesive force of the adhesive may be insufficient, and if the content exceeds 20 parts by weight, the cohesive force before ultraviolet irradiation may be insufficient, which results in chip scattering, etc.

The cohesive layer may further contain a tackifier such as a rosin resin, a terpene resin, a phenol resin, a styrene resin, an aliphatic petroleum resin, an aromatic petroleum resin, or an aliphatic aromatic copolymer petroleum resin.

The thickness of the cohesive layer is not particularly limited, but may be in the range of 1 *µ*m to 500 *µ*m, for example.

Meanwhile, as mentioned above, the adhesive layer is formed on the cohesive layer and may include the adhesive film for a semiconductor of the embodiment described above. The details of the adhesive film for a semiconductor includes all of the matters described above in the other embodiments.

The method for producing the above-mentioned dicing die bonding film is not particularly limited, and for example, a method of sequentially forming a cohesive part, an adhesive part, and a release film on a substrate film, or a method of separately producing a dicing film (substrate film + cohesive part) and a die-bonding film or a release film on which an adhesive part is formed, and then laminating them to each other may be used.

Meanwhile, according to another embodiment of the present disclosure, there can be provided a method for dicing a semiconductor wafer, comprising a pre-treatment step of partially treating a semiconductor wafer including the dicing die bonding film of the other embodiments and a wafer laminated on at least one side of the dicing die bonding film so that it is completely cut or it can be cut; a step of irradiating UV to the substrate film of the pre-treated semiconductor wafer, and picking up individual chips separated by cutting of the semiconductor wafer.

The details of the dicing die bonding film includes all of the contents described above in the other embodiments.

Except for the details of the steps of the dicing method, commonly known apparatuses used for dicing of a semiconductor wafer, dicing methods, and the like may be used without particular limitations.

The method for dicing a semiconductor wafer may further comprise a step of expanding the semiconductor wafer after the pre-treatment step. In this case, a step of irradiating UV to the substrate film of the expanded semiconductor wafer, and picking up individual chips separated by cutting of the semiconductor wafer is subsequently performed.

By using the dicing die bonding film including a dicing film, incidence of burrs may be minimized during a dicing process of a semiconductor wafer to prevent pollution of semiconductor chips and improve reliability and lifespan of semiconductor chips.

Meanwhile, according to yet another embodiment of the present disclosure, there can be provided a semiconductor device, comprising: a substrate; one or more semiconductor chips formed on the substrate; and an adhesive layer located between the substrate and the semiconductor chips formed on the substrate, or between two or more semiconductor chips among the semiconductor chips.

In this case, the adhesive layer may comprise a cured product of the adhesive composition for a semiconductor package of the above embodiment.

The semiconductor chip may have a thickness of 100 µm or less, 50 µm or less, 40 µm or less, 30 µm or less, or 1 µm or more, 2 µm or more, 5 µm or more, or 10 µm or more.

In the process of obtaining a cured product of the adhesive composition for semiconductor package, the curing conditions are not particularly limited, and for example, the curing may be performed under conditions of a temperature of 120°C to 300°C and a pressure of 0.5 Kgf/cm² to 10 Kgf/cm². However, as mentioned above, the curing conditions do not limit the specific application or usage form of the adhesive composition for the semiconductor package.

The storage modulus of the adhesive layer at 130°C measured after the curing may be 30 MPa or more, or 50 to 500 MPa, or 60 to 400 MPa.

More specific details of the adhesive layer include those described above with respect to the adhesive composition for a semiconductor packages of the embodiment.

The semiconductor device of the above embodiment may have high reliability and internal structural stability even while including a semiconductor chip having a thin thickness.

The melt viscosity measured at 110° C by applying a shear rate of 5 rad/s to the adhesive composition for a semiconductor package may be 3,000 Pa·s to 50,000 Pa·s, or 4,000 Pa·s to 30,000 Pa·s, or 4,500 Pa·s to 25,000 Pa·s, or 4,000 Pa·s to 20,000 Pa·s.

The adhesive composition for a semiconductor package of the above embodiment has the above-mentioned melt viscosity at 110°C, and thus can efficiently fill a space formed between a substrate and a semiconductor chip or between two or more semiconductor chips, thereby preventing the occurrence of voids and the deterioration of the connection state.

Since the storage modulus of the adhesive layer at 130°C is 30 MPa, it is possible to greatly reduce stress applied to the semiconductor chip or greatly reduce strain of the semiconductor chip while firmly bonding with a semiconductor chip having a thin thickness, which makes it possible to prevent occurrence of cracks and warpage in the semiconductor chip even during a packaging process using a semiconductor chip having a thin thickness.

Meanwhile, according to another embodiment of the present disclosure, there can be provided a method for manufacturing a semiconductor device, the method comprising a step of curing the adhesive layer under the conditions of a temperature of 120°C to 300°C and a pressure of 0.5 Kgf/cm² to 10 Kgf/cm² in a state where an adhesive layer is formed between a substrate and a semiconductor chip formed on the substrate, or between two or more semiconductor chips.

At this time, the adhesive layer may include a cured product of the adhesive composition for a semiconductor package of the above embodiment.

However, as mentioned above, the curing conditions do not limit the specific application or usage form of the adhesive composition for a semiconductor package.

The semiconductor chip may have a thickness of 100 µm or less, or 50 ym or less, 40 µm or less, 30 µm or less, or 1 µm or more, 2 µm or more, 5 µm or more, or 10 µm or more.

More specific details of the adhesive layer include the contents described above regarding the adhesive composition for a semiconductor package of the above embodiment.

In the method for manufacturing the semiconductor device, a conventional semiconductor package method may be used, except for those described above.

### Advantageous Effects

According to the present disclosure, an adhesive composition for a semiconductor package that can prevent occurrence of cracks or warpage in semiconductor chips even during a packaging process applying a semiconductor chip having a thin thickness, and are excellent in adhesive force and embedding properties, an adhesive film for semiconductor comprising the adhesive composition for a semiconductor package, and a dicing die bonding film comprising the adhesive film for semiconductor can be provided.

A semiconductor device having high reliability and internal structural stability even while including a semiconductor chip having a thin thickness, and a method for manufacturing a semiconductor device that can prevent occurrence of cracks or warpage in semiconductor chips even during a packaging process applying a semiconductor chip having a thin thickness, and can realize excellent adhesive force and embedding properties between a substrate and a semiconductor chip or between two or more semiconductor chips can be provided.

### BRIEF DESCRIPTION OF THE DRAWINGS

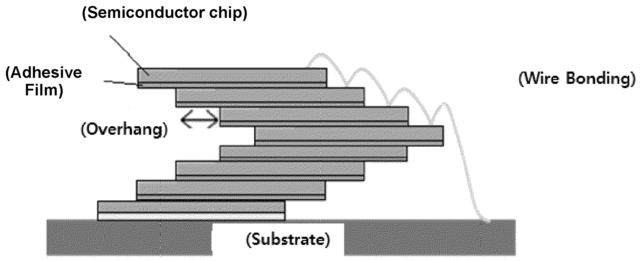

The Figure is a schematic diagram illustrating a semiconductor device having an overhang structure used in die-deflection evaluation among Test Examples.

### EXAMPLES

Hereinafter, preferable examples are presented for better understanding the present disclosure. However, the following examples are only for illustrating the present disclosure, and the present disclosure is not limited to or by them.

### [Preparation Example: Preparation of thermoplastic acrylate resin]

### Preparation Example 1

### (Preparation of thermoplastic acrylate resin)

40 g of butyl acrylate, 30 g of ethyl acrylate, 30 g of acrylonitrile, 5 g of methyl methacrylate, and 5 g of glycidyl methacrylate were mixed with 100 g of toluene, and then reacted at 80°C for about 12 hours to synthesize an acrylate-based resin (weight average molecular weight: 1,000,000 g/mol, glass transition temperature: 15°C) in which a glycidyl group was introduced as a branched chain.

### Preparation Example 2

### (Preparation of thermoplastic acrylate resin)

70 g of butyl acrylate, 25 g of acrylonitrile, 5 g of methyl methacrylate, and 10 g of glycidyl methacrylate were mixed with 100 g of toluene, and then reacted at 80°C for about 12 hours to synthesize an acrylate-based resin (weight average molecular weight: 600,000 g/mol, glass transition temperature: -5°C) in which a glycidyl group was introduced as a branched chain.

### [Example: Preparation of adhesive composition for a semiconductor package]

### Examples 1 to 6

### (1) Preparation of adhesive composition for a semiconductor package

The components and contents shown in Table 1 below were applied and mixed with methyl ethyl ketone to obtain an adhesive composition for a semiconductor package (solid content: 20 wt.%).

### (2) Production of adhesive film

The adhesive composition was applied onto a release-treated polyethylene terephthalate film (thickness 38 *µ*m) using a comma coater, and then dried at 110°C for 3 minutes to obtain an adhesive film formed with an adhesive layer of about 20 *µ*m in thickness.

### (3) Measurement of melt viscosity of adhesive film

The obtained adhesive film was laminated using a roll laminator at 60°C, laminated to a thickness of 640 *µ*m, and then molded into a circle with a diameter of 8 mm. The melt viscosity of the adhesive film was then measured using TA Instruments ARES-G2. At this time, the melt viscosity was a viscosity value measured at 110°C by applying a temperature increase rate of 20°C/min at a shear rate of 5 Rad/s.

### (4) Measurement of storage modulus at 130°C of the adhesive film

The obtained adhesive film was laminated using a roll laminator at 60°C, and laminated to a thickness of 640 *µ*m to prepare a sample.

The prepared sample was placed in a pressurized curing oven (PCO, available from CMT), and the temperature was increased from 25°C to 125°C under the pressure condition of 7 kgf/cm² for 30 minutes. After the temperature increase, the temperature was maintained at 125°C for 30 minutes, and cooled to 60°C after the maintaining, thereby performing curing.

And, the sample that had undergone the curing process was molded into a square with a length of 17.5 mm and a width of 5.3 mm, processed into a measurement sample, and the temperature was increased from -30°C to 280°C at a rate of 10°C per minute at a frequency of 1Hz and a strain of 0.0% using a DMA (Dynamic mechanical analyzer, TA Instruments DMA Q800) to measure the storage modulus(G') according to the temperature. Thereby, the storage modulus(G') at 130°C of the adhesive film was measured.

### (5) Production of dicing die bonding film

The adhesive film produced in the above (2) was transferred to a dicing film (cohesive layer with a thickness of 10 *µ*m and polyolefin film with a thickness of 100 *µ*m) to produce a dicing die bonding film.

### (6) Manufacturing of semiconductor device

After the release-treated polyethylene terephthalate film was peeled off from the dicing die bonding film produced above, the prepared semiconductor wafer was pressurized and bonded on the upper part of the adhesive layer, and a laser was focused inside the wafer to selectively form a modified part. Then, the adhesive film attached to the semiconductor chip was individualized through physical tension at a low temperature of -10°C.

The individualized chip was die-bonded to a substrate or chip substrate using a die bonder (Shinkawa, SPA-400). At that time, temporary bonding was performed under the conditions of about 1.5 kgf/cm² at 110°C for 0.5 seconds. Then, curing was performed under the conditions of a temperature of 125°C and a pressure of 7 Kgf/cm² in a pressurized oven (CMT, Pressurized Cure Oven PCO) for 30 minutes.

**[Table 1]**

| Weight (g) | | Example 1 | Example 2 | Example 3 | Example 4 | Example 5 | Example 6 |
|---|---|---|---|---|---|---|---|
| Thermoplastic resin | Preparation Example 1 | 30 | 30 | 40 | 50 | 50 | 50 |
| | Preparation Example 2 | 30 | 30 | 10 | 30 | 50 | 50 |
| Thermosetting resin | EOCN-104S | 40 | 30 | 20 | 30 | 30 | 30 |
| | EP0409 | 10 | 20 | 20 | 10 | 10 | 10 |
| | NC-3000 | 5 | 5 | 5 | 5 | 5 | 5 |
| Curing agent | GPH-65 | 40 | 40 | 45 | 40 | 40 | 40 |
| | KA-1160 | 10 | 10 | 5 | 10 | 10 | 10 |
| Inorganic filler | YA-050C | | | | | | 10 |
| Additive | 2MZ-A | 4 | 4 | 4 | 4 | 4 | 4 |
| Melting viscosity of adhesive film at 110°C | | 6,100 | 5,600 | 4,700 | 9,800 | 16,200 | 19,400 |
| Storage elastic modulus (MPa) of adhesive film at 130°C after curing | | 302 | 342 | 371 | 149 | 52 | 56 |

### [Comparative Example]

An adhesive composition for a semiconductor package was prepared in the same manner as in Example 1, except for applying the components and contents shown in Table 2 below. Then, an adhesive film was produced using the adhesive composition in the same manner as in Example 1, and this was used to manufacture a dicing die bonding film and a semiconductor device.

**[Table 2]**

| Weight (g) | | Comparative Example 1 | Comparative Example 2 |
|---|---|---|---|
| Thermoplastic resin | Preparation Example 1 | 180 | 30 |
| Thermosetting resin | EOCN-104S | 20 | 20 |
| | EP0409 | - | - |
| | EPPN-201L | | |
| | NC-3000 | 10 | 10 |
| Curing agent | GPH-65 | 30 | 30 |
| | KA-1160 | 5 | |
| Inorganic filler | YA-050C | 25 | 90 |
| Additive | C11Z-CNS | | |
| | 2MZ-A | 0.3 | 2 |
| Melting viscosity of adhesive film at 110°C | | 57,000 | 2,300 |
| Storage elastic modulus of adhesive film at 130°C after curing | | 3 | 5 |

The components listed in Tables 1 and 2 above are as follows.
*EPPN-201L: Solid epoxy resin (Nippon Kayaku, epoxy equivalent: 190 g/eq.)
*NC-2000L: Solid epoxy resin (Nippon Kayaku, epoxy equivalent: 237 g/eq.)
*EOCN-104S: Solid epoxy resin (Nippon Kayaku, epoxy equivalent: 218 g/eq.)
*NC-3000: Solid epoxy resin (Nippon Kayaku, epoxy equivalent: 275 g/eq.)
*KDS-8170: Liquid epoxy resin (Kukdo Chemical, epoxy equivalent: 157 g/eq.)
*CEL2021P: Liquid epoxy resin (DAICEL, epoxy equivalent: 130 g/eq.)
*RE-310S: Liquid epoxy resin (Nippon Kayaku, epoxy equivalent: 180 g/eq.)
*EP0408: Organic-inorganic hybrid epoxy resin having the repeating unit of Chemical Formula 1 (epoxy equivalent: 177 g/eq., epoxycyclohexyl POSS, (C₈H₁₃O)ₙ(SiO_{1.5})ₙ, viscosity: 500 Pa.s, Hybrid plastics)
*EP0409: Organic-inorganic hybrid epoxy resin having the repeating unit of Chemical Formula 1 (Epoxy equivalent 167 g/eq., Glycidyl POSS, (C₆H₁₁O₂)ₙ(SiO_{1.5})ₙ, viscosity 48 Pa.s, Hybrid plastics)
*GPH-65: Phenol resin (Nippon Kayaku, hydroxyl equivalent: 198 g/eq, softening point: 65 °C)
*KA-1160: Phenol resin (DIC, hydroxyl equivalent: 117 g/eq, softening point: 86°C)
*KH-6021: Phenol resin (DIC, hydroxyl equivalent: 121 g/eq, softening point: 133°C)
*KPH-F3075: Phenol resin (Kolon Emulsifier, hydroxyl equivalent: 175 g/eq., softening point: 75 °C)
*YA-050C: Filler (Admatechs, spherical silica, average particle size: about 50 nm)
*2MZ-A: Imidazole curing accelerator (SHIKOKU)

### [Test Example]

The following tests were performed on the adhesive compositions, adhesive films, and semiconductor devices according to the Examples and Comparative Examples, and the results are shown in Tables 3 and 4 below.

### (1) Evaluation of Die detachment

A semiconductor wafer (diameter: 12 inches, thickness: 500 *µ*m) was subjected to backside polishing to manufacture a semiconductor wafer having a thickness of 100 *µ*m.

After the release-treated polyethylene terephthalate film was peeled off from the dicing die bonding film produced in each of the Examples and Comparative Examples, the prepared semiconductor wafer was pressurized and bonded on the upper part of the adhesive layer, and a laser was focused inside the wafer to selectively form a modified part. Then, dicing was performed using a stealth dicing method that individualizes the wafer together with the adhesive layer along the selectively modified lines through physical tension at a low temperature of -10°C. The detachment of the adhesive layer was confirmed for the semiconductor wafer and dicing die bonding film after cutting.

It was evaluated as a bad level if detachment occurred in the adhesive layer, and it was evaluated as a good level if no detachment occurred.

### (2) Void Evaluation

Evaluation was performed for the semiconductor devices obtained in each of the Examples and Comparative Examples through Scanning Acoustic Tomography(SAT). It was evaluated as a good level if the area occupied by voids inside the semiconductor device was 1% or less, and as a bad level if the area exceeded 1%.

### (3) Chip Crack Evaluation

After the semiconductor devices obtained in each of the Examples and Comparative Examples were subjected to epoxy molding and temperature cycling test, the presence or absence of cracks in the chip was observed on the cross section using an optical microscope(SEM). It was evaluated as a good level if no cracks occurred, and as a bad level if cracks occurred.

### (4) Die-deflection evaluation

The 20 *µ*m thick adhesive film obtained in each of the Examples and Comparative Examples was bonded to a 60 *µ*m semiconductor wafer, and each chip was individualized. As shown in the Figure, the semiconductor chip was die-bonded to a base chip to manufacture a semiconductor device having an overhang structure of 750 *µ*m.

After curing, the length of the overhang deflection was measured and evaluated. It was evaluated as a good level if the height was within 2 *µ*m, and as a bad level if the height exceeded 2 *µ*m.

### (5) Reliability Evaluation (Thermal Cycle Test)

For the semiconductor device obtained in each of the Examples and Comparative Examples, ten samples were prepared, and processed under the conditions of a thermal cycle tester of -65°C to 150°C, with the lowest and highest temperatures being supported for 45 minutes each, and the presence or absence of peeling was evaluated.

After the completion of 500 cycles, it was evaluated as a good level if none of 10 samples had any peeling through Scanning Acoustic Tomography(SAT), and as a bad level if even one peeling was confirmed.

**[Table 3]**

| | Example 1 | Example 2 | Example 3 | Example 4 | Example 5 | Example 6 |
|---|---|---|---|---|---|---|
| Melt viscosity of adhesive film (Pa.s) | 6,100 | 5,600 | 4,700 | 9,800 | 16,200 | 19,400 |
| Presence or absence of die detachment | Good | Good | Good | Good | Good | Good |
| Void | Good | Good | Good | Good | Good | Good |
| Presence or absence of Chip Crack | Good | Good | Good | Good | Good | Good |
| Die Deflection (µm) | 1.4 | 1.4 | 1.4 | 1.4 | 1.5 | 1.6 |
| Reliability | Good | Good | Good | Good | Good | Good |

**[Table 4]**

| | Comparative Example 1 | Comparative Example 2 |
|---|---|---|
| Melt viscosity of adhesive film (Pa.s) | 57,000 | 2,300 |
| Presence or absence of die detachment | Bad | Good |
| Void | Bad | Good |
| Presence or absence of Chip Crack | Bad | Bad |
| Die Deflection (µm) | 2.1 | 2.0 |
| Reliability | Bad | Bad |

Referring to Table 3, it was confirmed that the adhesive compositions of the Examples or the adhesive films produced therefrom have a storage modulus at 130°C of 30 MPa or more as measured after curing under the conditions of a temperature of 120°C to 300°C and a pressure of 0.5 Kgf/cm² to 10 Kgf/cm², and a melt viscosity of 4,000 Pa·s or more.

It was confirmed that even during the packaging process applying semiconductor chips having thin thickness according to the Examples, it is possible to prevent occurrence of cracks or warpage in the semiconductor chips, and to achieve excellent adhesion and embedding properties, and in particular, the die detachment phenomenon and chip crack phenomenon do not occur, and the die deflection of the Experimental Example is also only 1.6 µm or less.

On the other hand, referring to Table 4, it was confirmed that the adhesive compositions according to Comparative Examples 1 and 2 induced void defects and poor connection conditions and failed to pass all thermal cycle tests, and also that a die detachment phenomenon and a chip crack phenomenon occurred, and the die deflection of Experimental Example reached 2.0 µm or more.

## Claims

1. An adhesive composition for a semiconductor package, comprising:
a thermoplastic resin, a thermosetting resin and a curing agent,
wherein a storage modulus at 130°C measured after curing under the conditions of a temperature of 120°C to 300°C and a pressure of 0.5 Kgf/cm² to 10 Kgf/ cm² is 30 MPa or more.

2. The adhesive composition of claim 1, wherein:
the curing under the conditions of a temperature of 120°C to 300°C and a pressure of 0.5 Kgf/ cm² to 10 Kgf/ cm² is performed under the pressure condition of 7 Kgf/ cm², which comprises:
a step of increasing the temperature from 25°C to 125°C for 30 minutes, a step of maintaining the temperature at 125°C for 30 minutes after the temperature increase, and a step of cooling the temperature to 60°C after the maintaining.

3. The adhesive composition of claim 1, wherein:
the adhesive composition does not contain an inorganic filler, or
the adhesive composition further contains an inorganic filler in an amount greater than 0 to 4.9 wt.% .

4. The adhesive composition of claim 1, wherein:
the adhesive composition connects a substrate and a semiconductor chip having a thickness of 100 µm or less, or connects two or more semiconductor chips having a thickness of 100 µm or less.

5. The adhesive composition of claim 1, wherein:
the storage modulus at 130°C measured after curing the adhesive composition under the conditions of a temperature of 120°C to 300°C and a pressure of 0.5 Kgf/ cm² to 10 Kgf/ cm² is 50 to 500 MPa.

6. The adhesive composition of claim 1, wherein:
a melt viscosity of the adhesive composition measured at 110°C by applying a shear rate of 5 rad/s is 3,000 Pa·s to 50,000 Pa·s

7. The adhesive composition of claim 1, wherein:
the thermoplastic resin comprises a (meth)acrylate-based resin containing a repeating unit substituted with a glycidyl group or an epoxy group.

8. The adhesive composition of claim 1, wherein:
the thermoplastic resin comprises:
a (meth)acrylate-based resin containing a repeating unit substituted with a glycidyl group or an epoxy group and having a glass transition temperature of -20°C to 5°C; and
a (meth)acrylate-based resin containing a repeating unit substituted with a glycidyl group or an epoxy group and having a glass transition temperature of 7°C to 30°C.

9. The adhesive composition of claim 1, wherein:
the thermosetting resin comprises a silsesquioxane compound substituted with a glycidyl group or an epoxy group.

10. The adhesive composition of claim 1, wherein:
the thermosetting resin further comprises at least one epoxy resin selected from the group consisting of a bisphenol-based epoxy resin, a biphenyl-based epoxy resin, a naphthalene-based epoxy resin, a fluorene-based epoxy resin, a phenol novolac-based epoxy resin, a cresol novolac-based epoxy resin, a xylok-based epoxy resin, a trishydroxylphenylmethane-based epoxy resin, a tetraphenylmethane-based epoxy resin, a dicyclopentadiene type epoxy resin, and a dicyclopentadiene-modified phenol type epoxy resin.

11. The adhesive composition of claim 1, wherein:
the curing agent comprises at least one selected from the group consisting of an amine-based curing agent, a phenol-based curing agent and an acid anhydride-based curing agent.

12. The adhesive composition of claim 1,
comprising 5 to 500 parts by weight of the thermoplastic resin and 1 to 150 parts by weight of the curing agent relative to 100 parts by weight of the thermosetting resin.

13. An adhesive film for a semiconductor, comprising the adhesive composition for a semiconductor package of claim 1.

14. A dicing die bonding film, comprising:
a substrate film;
a cohesive layer formed on the substrate film; and
an adhesive layer formed on the cohesive layer and containing the adhesive film for a semiconductor of claim 13.

15. A semiconductor device, comprising:
a substrate;
one or more semiconductor chips formed on the substrate; and
an adhesive layer located between the substrate and the semiconductor chips formed on the substrate or between two or more semiconductor chips among the semiconductor chips,
wherein the adhesive layer comprises a cured product of the adhesive composition for a semiconductor package of claim 1.

16. The semiconductor device of claim 15, wherein:
a thickness of each of the semiconductor chips is 100 µm or less.
